# EUROPEAN PATENT APPLICATION

(11) **EP 2 315 266 A2**
(43) Date of publication of application: **27.04.2011**
(21) Application number: 10187825.4
(22) Date of filing: 15.10.2010
(51) Int. Cl.: H01L 33/00, H01L 33/22

(54) **Light emitting device, method of manufacturing the same, light emitting device package and lighting system**

(30) Priority: 21.10.2009 KR 20090100072
(71) Applicant: LG Innotek Co., Ltd., Seoul 100-714 (KR)
(72) Inventor: Jeong, Hwan Hee, 100-714, Seoul (KR); Kim, So Jung, 100-714, Seoul (KR); Song, June O, 100-714, Seoul (KR); Choi, Kwang Ki, 100-714, Seoul (KR)
(74) Representative: Cabinet Plasseraud

(57) **Abstract**

A method of manufacturing a light emitting device according to the embodiment includes the steps of partially forming a first buffer layer on a growth substrate, in which the first buffer layer has a Young's modulus smaller than that of the growth substrate; and forming a light emitting structure layer on the growth substrate and the first buffer layer, in which the light emitting structure layer includes a first conductive semiconductor layer, a second conductive semiconductor layer and an active layer interposed between the first and second conductive semiconductor layers.

## Description

The present application claims priority of Korean Patent Application No. 10-2009-0100072 filed on October 21, 2009, which is hereby incorporated by reference in its entirety.

### BACKGROUND

The embodiment relates to a light emitting device, a method of manufacturing the same, a light emitting device package and a lighting system.

Recently, a light emitting diode (LED) has been extensively used as a light emitting device.

The LED is manufactured by using compound semiconductor materials, such as GaAs, AlGaAs, GaN, InGaN or AlGalnP, to reproduce light having various colors. The LED has a light emitting structure layer including a first conductive semiconductor layer, an active layer, and a second conductive semiconductor layer and emits light through the active layer as power is applied thereto through the first and second conductive semiconductor layers.

### SUMMARY

The embodiment provides a light emitting device having a novel structure, a method of manufacturing the same, a light emitting device package and a lighting system.

The embodiment provides a light emitting device having a light emitting structure layer, which can be easily separated from a growth substrate, a method of manufacturing the same, a light emitting device package and a lighting system.

The embodiment provides a light emitting device capable of preventing a light emitting structure layer from being damaged, a method of manufacturing the same, a light emitting device package and a lighting system.

A method of manufacturing a light emitting device according to the embodiment may include the steps of partially forming a first buffer layer on a growth substrate in which the first buffer layer has a Young's modulus smaller than that of the growth substrate; and forming a light emitting structure layer on the growth substrate and the first buffer layer, in which the light emitting structure layer includes a first conductive semiconductor layer, a second conductive semiconductor layer and an active layer interposed between the first and second conductive semiconductor layers.

A light emitting device according to the embodiment may include a light emitting structure layer including a first conductive semiconductor layer, a second conductive semiconductor layer and an active layer interposed between the first and second conductive semiconductor layers, wherein a first surface of the first conductive semiconductor layer faces the active layer and a plurality of protrusions are formed on a second surface of the first conductive semiconductor layer, and wherein the second surface of the first conductive semiconductor layer includes a peripheral portion and a central portion surrounded by the peripheral portion, and the protrusions are formed on the central portion while being spaced apart from each other.

### BRIEF DESCRIPTION OF THE DRAWINGS

FIG. 1 is a sectional view showing a light emitting device according to the first embodiment;
FIG. 2 is a sectional view showing a light emitting device according to the second embodiment;
FIGS. 3 and 4 are views showing a first buffer layer formed on a growth substrate of a light emitting device according to the first embodiment;
FIG. 5 is a view showing laser irradiation regions onto which laser beams are irradiated when a light emitting structure layer is separated from a growth substrate through a laser liftoff scheme;
FIGS. 6 to 8 are sectional views showing a method of manufacturing a light emitting device according to the embodiment;
FIG. 9 is a sectional view showing a light emitting device package including a light emitting device according to the embodiment;
FIG. 10 is an exploded perspective view showing a backlight unit including a light emitting device or a light emitting device package according to the embodiment; and
FIG. 11 is a perspective view showing a lighting unit including a light emitting device or a light emitting device package according to the embodiment.

### DETAILED DESCRIPTION OF THE EMBODIMENTS

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" on the other substrate, layer (or film), region, pad, or pattern, or one or more intervening layers may also be present. Such a position of the layer has been described with reference to the drawings.

The thickness and size of each layer shown in the drawings may be exaggerated, omitted or schematically drawn for the purpose of convenience or clarity. In addition, the size of elements does not utterly reflect an actual size.

Hereinafter, a light emitting device and a method of manufacturing the same according to the embodiments will be described in detail with reference to accompanying drawings.

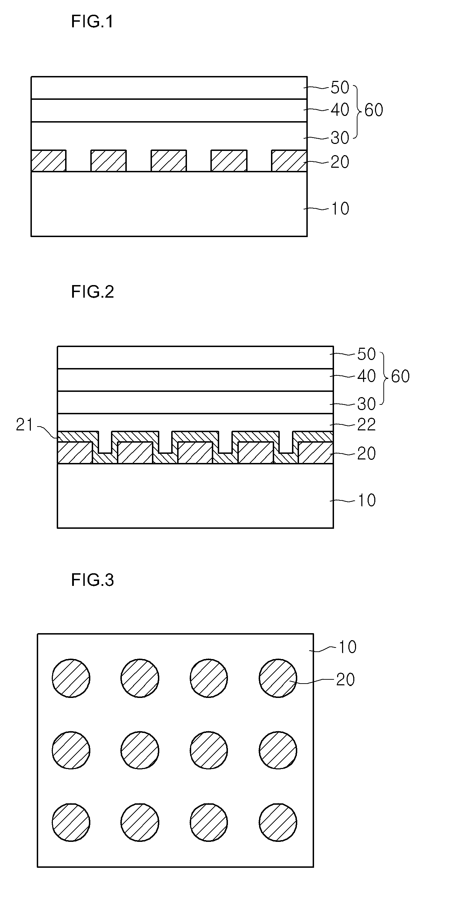

FIG. 1 is a sectional view showing a light emitting device according to the first embodiment.

Referring to FIG. 1, the light emitting device according to the first embodiment includes a growth substrate 10, a first buffer layer 20 partially formed on the growth substrate 10, a first conductive semiconductor layer 30 formed on the first buffer layer 20, an active layer 40 formed on the first conductive semiconductor layer 30, and a second conductive semiconductor layer 50 formed on the active layer 40.

The first conductive semiconductor layer 30, the active layer 40, and the second conductive semiconductor layer 50 constitute a light emitting structure layer 60 which generates a light as power is applied thereto.

For instance, the growth substrate 10 may include at least one of Al₂O₃, SiC, GaAs, GaN, ZnO, Si, GaP, InP, and Ge, but the embodiment is not limited thereto.

The first buffer layer 20 is partially formed on the growth substrate 10 through the chemical vapor deposition, physical vapor deposition or evaporation. For example, the first buffer layer 20 is partially formed on the growth substrate 10 through the sputtering process. When viewed in a plan view, the first buffer layer 20 may have a periodic pattern or a random pattern with a thickness of about 0.1nm∼5.0µm. In addition, the first buffer layer 20 may have a substantially planar top surface.

The first buffer layer 20 may have the bandgap energy between the bandgap energy of a semiconductor layer constituting the light emitting structure layer 60 and the bandgap energy of the growth substrate 10. For instance, if the light emitting structure layer 60 is a GaN-based semiconductor layer having the bandgap energy of 3.4eV and the growth substrate 10 is a sapphire substrate having the bandgap energy of 9.9eV, the first buffer layer 20 may have the bandgap energy in the range of 3.4eV to 9.9eV. For instance, the first buffer layer 20 may have the bandgap energy of 5 to 6eV.

In addition, the first buffer layer 20 may include a material having the Young's modulus smaller than that of the growth substrate 10.

For example, the first buffer layer 20 may include oxide or nitride including at least one of Al, Ta, Ti, Mo, W, Pd, Ir, Rb, Si, and Cr. For instance, the first buffer layer 20 may include Al₂O₃. The first buffer layer 20 including Al₂O₃ formed on the sapphire substrate through the sputtering process may have the bandgap energy smaller than that of the sapphire substrate.

The first buffer layer 20 is partially formed on the growth substrate 10 in such a manner that the growth substrate 10 can be partially exposed. For example, the first buffer layer 20 formed on the growth substrate 10 may have an area corresponding to 30% to 95% based on the total area of the growth substrate 10. If the first buffer layer 20 formed on the growth substrate 10 has an area less than 30% based on the total area of the growth substrate 10, the effect derived from the first buffer layer 20 may be lowered. In addition, if the first buffer layer 20 formed on the growth substrate 10 has an area more than 95% based on the total area of the growth substrate 10, the light emitting structure layer 60 may not be effectively formed on the growth substrate 10.

When the first buffer layer 20 is formed through the sputtering process, the first conductive semiconductor layer 30 can be effectively grown on a predetermined region of the growth substrate 10 where the first buffer layer 20 is not formed as compared with other regions of the growth substrate 10 where the first buffer layer 20 is formed.

In addition, before the first conductive semiconductor layer 30 is formed, an undoped nitride layer can be formed on the first buffer layer 20. For instance, the undoped nitride layer includes an undoped GaN layer.

For instance, the first conductive semiconductor layer 30 includes an n type semiconductor layer. The first conductive semiconductor layer 30 may include semiconductor materials having the compositional formula of InₓAl_{y}Ga_{1-x-y}N (0≤5x≤1, 0≤5y≤1, 0≤5x+y:≤1), such as InAlGaN, GaN, AlGaN, AllnN, InGaN, AIN, or InN. In addition, the first conductive semiconductor layer 30 may be doped with n type dopant such as Si, Ge or Sn.

The active layer 40 emits the light based on the bandgap difference of the energy band determined according to the intrinsic material of the active layer 40 through the recombination of electrons (or holes) injected through the first conductive semiconductor layer 30 and holes (or electrons) injected through the second conductive semiconductor layer 50.

The active layer 40 may have a single quantum well structure, a multiple quantum well (MQW) structure, a quantum wire structure or a quantum dot structure, but the embodiment is not limited thereto.

The active layer 40 may include semiconductor materials having the compositional formula of InₓAl_{y}Ga_{1-x-y}N (0≤5x≤1, 0≤y≤1, 0≤x+y≤1). If the active layer 40 has the MQW structure, the active layer 40 has a stack structure including a plurality of well layers and a plurality of barrier layers. For instance, the active layer 40 may have a stack structure of an InGaN well layer/a GaN barrier layer.

A clad layer (not shown) doped with the n type or p type dopant can be formed on and/or under the active layer 30. The clad layer may include an AlGaN layer or an InAlGaN layer.

The second conductive semiconductor layer 50, for example, includes a p type semiconductor layer. The second conductive semiconductor layer 50 may include semiconductor materials having the compositional formula of InₓAl_{y}Ga_{1-x-y}N (0≤x≤1, 0≤y≤1, 0≤x+y≤1), such as InAlGaN, GaN, AlGaN, InGaN, AllnN, AIN, or InN. In addition, the second conductive semiconductor layer 50 may be doped with p type dopant such as Mg, Zn, Ca, Sr, or Ba.

Meanwhile, the first conductive semiconductor layer 30 may include a p type semiconductor layer and the second conductive semiconductor layer 50 may include an n type semiconductor layer. In addition, a third conductive semiconductor layer (not shown) including an n type or a p type semiconductor layer can be formed on the second conductive semiconductor layer 50. Thus, the light emitting structure layer 60 may have at least one of NP, PN, NPN and PNP junction structures. In addition, the impurities can be uniformly or non-uniformly doped in the first and second conductive semiconductor layers 30 and 50. That is, the light emitting structure layer 60 may have various structures and the embodiment is not limited thereto.

In other words, the light emitting structure layer 60 including the first conductive semiconductor layer 30, the active layer 40 and the second conductive semiconductor layer 50 can be variously modified without limitation.

Meanwhile, the first buffer layer 20 formed on the growth substrate 10 attenuates the stress of the light emitting structure layer 60 grown on the growth substrate 10 and prevents the light emitting structure layer 60 from being damaged when the light emitting structure layer 60 is separated from the growth substrate 10.

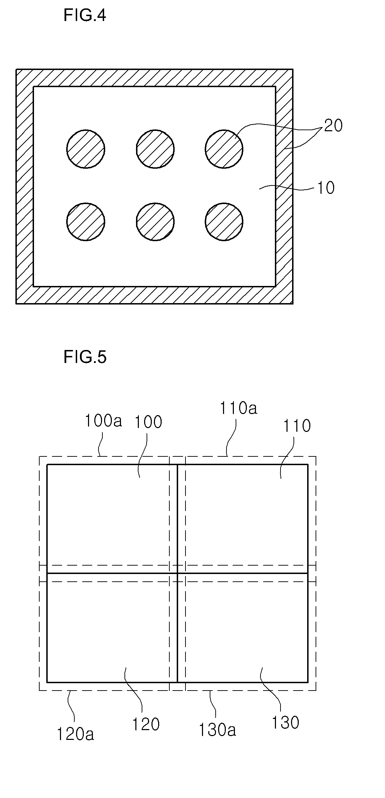

FIGS. 3 and 4 are views showing the first buffer layer formed on the growth substrate of the light emitting device according to the first embodiment.

The first buffer layer 20 may have patterns which are regularly or irregularly formed with various shapes. Referring to FIG. 3, the first buffer layer 20 has circular patterns regularly spaced apart from each other. Referring to FIG. 4, the first buffer layer 20 is continuously formed along an outer peripheral surface of the growth substrate 10 with circular patterns regularly spaced apart from each other on the exposed surface of the growth substrate 10. In addition, the first buffer layer 20 can be formed along an outer peripheral surface of the growth substrate 10 with circular patterns irregularly spaced apart from each other on the exposed surface of the growth substrate 10. The patterns of the first buffer layer 20 may have circular shapes or polygonal shapes.

FIG. 5 is a view showing laser irradiation regions onto which laser beams are irradiated when the light emitting structure layer is separated from the growth substrate through the laser liftoff scheme.

In order to separate the light emitting structure layer 60 from the growth substrate 10, the laser beam having the wavelength of 248nm or 193nm is irradiated onto the growth substrate 10 such that the thermo-chemical decomposition may occur at the interfacial surface between the growth substrate 10 and the light emitting structure layer 60.

As shown in FIG. 5, the light emitting structure layer 60 is formed over the whole area of the growth substrate 10 in such a manner that a plurality of light emitting devices can be manufactured. The light emitting structure layer 60 is divided into a plurality of light emitting structure layers 60 through the isolation process. The laser beams are irradiated onto unit regions 100, 110, 120 and 130 corresponding to the light emitting structure layers 60. In detail, the laser beams are irradiated onto laser irradiation regions 100a, 110a, 120a and 130a slightly wider than the unit regions 100, 110, 120 and 130.

Thus, the laser beams are overlapped several times at peripheral portions of the unit regions 100, 110, 120 and 130 adjacent to each other, so that the light emitting structure layer 60 may be damaged by the laser beams.

Meanwhile, according to the light emitting device and the method of manufacturing the same of the first embodiment, the first buffer layer 20 may serve as an energy absorption layer to prevent the light emitting structure layer 60 from being damaged by reducing the amount of energy irradiated onto the light emitting structure layer 60.

In particular, since the first buffer layer 20 is formed at the outer peripheral portion of the growth substrate 10 as shown in FIG. 4, the light emitting structure layer 60 can be prevented from being damaged even if the laser beams are overlapped at the peripheral portion of the growth substrate 10.

In addition, since the first buffer layer 20 has the bandgap energy between the bandgap energy of the growth substrate 10 and the bandgap energy of the light emitting structure layer 60, the first buffer layer 20 may absorb the energy of laser beams incident into the growth substrate 10, thereby separating the light emitting structure layer 60 from the growth substrate 10 through the thermo-chemical decomposition while preventing the light emitting structure layer 60 from being damaged 60.

FIG. 2 is a sectional view showing a light emitting device according to the second embodiment.

In the following description of the light emitting device and the method of manufacturing the same according to the second embodiment, the elements and structures described in the first embodiment will be omitted in order to avoid redundancy.

Referring to FIG. 2, the light emitting device according to the second embodiment includes a growth substrate 10, a first buffer layer 20 partially formed on the growth substrate 10, a second buffer layer 21 formed on the growth substrate 10 and the first buffer layer 20, an undoped nitride layer 22 formed on the second buffer layer 21, a first conductive semiconductor layer 30 formed on the undoped nitride layer 22, an active layer 40 formed on the first conductive semiconductor layer 30, and a second conductive semiconductor layer 50 formed on the active layer 40.

Different from the light emitting device according to the first embodiment, the light emitting device according to the second embodiment further includes the second buffer layer 21 and the undoped nitride layer 22 between the first conductive semiconductor layer 30 and the growth substrate 10. Although both of the second buffer layer 21 and the undoped nitride layer 22 are shown in FIG. 2, one of the second buffer layer 21 and the undoped nitride layer 22 may be omitted.

The second buffer layer 21 may attenuate the defect caused by the lattice mismatch between the growth substrate 10 and the light emitting structure layer 60, and the undoped nitride layer 22 may improve the quality of the light emitting structure layer 60.

The second buffer layer 21 can be formed on the first buffer layer 20 and the growth substrate 10 with a thickness smaller than that of the first buffer layer 20. The second buffer layer 21 may make contact with the growth substrate 10 exposed through the first buffer layer 20. In addition, at least a part of the second buffer layer 21 is aligned on the same plane with the first buffer layer 20. Further, the undoped nitride layer 22 makes contact with the second buffer layer 21 and at least a part of the undoped nitride layer 22 is aligned on the same plane with the first buffer layer 20. The second buffer layer 21 can be formed through the sputtering process. When the second buffer layer 21 is formed through the sputtering process, the thickness of the buffer layer 21 formed on the first buffer layer 20 and the growth substrate 10 is thicker than the thickness of the second buffer layer 21 formed at the lateral side of the first buffer layer 20.

For instance, the second buffer layer 21 can be prepared as a single layer or a multiple layer by using at least one of AIN, GaN, InN, GaBN, AlGaN, AllnGaN, and InGaN. The undoped nitride layer 22 may include an undoped GaN layer.

According to the light emitting device of the first and second embodiments, the first buffer layer 20 is partially formed on the growth substrate 10, and the light emitting structure layer 60 is formed on the growth substrate 10 and the first buffer layer 20. The second buffer layer 21 is formed over the whole area of the growth substrate 10 and the first buffer layer 20, and the undoped nitride layer 22 is formed on the second buffer layer 21.

Meanwhile, in the light emitting device shown in FIGS. 1 and 2, the second conductive semiconductor layer 50, the active layer 40 and the first conductive semiconductor layer 30 are selectively removed through the mesa etching process. In this state, a first electrode layer is formed on the first conductive semiconductor layer 30 and a second electrode layer is formed on the second conductive semiconductor layer 50, thereby manufacturing the lateral type light emitting device.

According to the embodiment, a first surface of the first conductive semiconductor layer 30 faces the active layer 40, and a second surface of the first conductive semiconductor layer 30 is formed with a plurality of protrusions 31. The second surface of the first conductive semiconductor layer 30 includes a peripheral portion and a central portion surrounded by the peripheral portion and the protrusions 31 are formed on the central portion while being spaced apart from each other.

The first buffer layer 20 and the growth substrate 10 are formed under the first conductive semiconductor layer 30 and at least a part of the first buffer layer 20 is interposed between the protrusions 31.

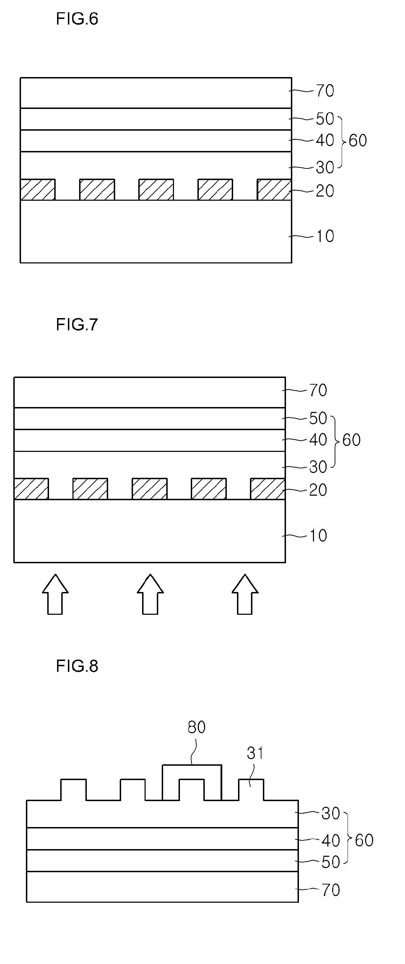

FIGS. 6 to 8 are sectional views showing the method of manufacturing the light emitting device according to the embodiment.
FIGS. 6 to 8 show the method of manufacturing the vertical type light emitting device.

Referring to FIG. 6, the first buffer layer 20 is partially formed on the growth substrate 10 through the sputtering process and the light emitting structure layer 60 including the first conductive semiconductor layer 30, the active layer 40 and the second conductive semiconductor layer 50 is formed on the growth substrate 10 and the first buffer layer 20 through the MOCVD process.

The second buffer layer 21 and the undoped nitride layer 22 shown in FIG. 2 are formed on the growth substrate 10 and the first buffer layer 20 through the MOCVD process.

In addition, the second electrode layer 70 is formed on the light emitting structure layer 60. The second electrode layer 70 may include a reflective layer and a conductive support substrate and an ohmic contact layer may be formed between the second conductive semiconductor layer 50 and the reflective layer.

Referring to FIGS. 7 and 8, the laser beam is irradiated onto the growth substrate 10 to separate the growth substrate 10 from the light emitting structure layer 60. For instance, the laser beam has the wavelength of 248nm or 193nm.

At this time, the first buffer layer 20 prevents the light emitting structure layer 60 from being damaged by the laser beam while allowing the growth substrate 10 to be easily separated from the light emitting structure 60.

In addition, as the first buffer layer 20 is removed, a plurality of protrusions 31 are formed on the top surface of the first conductive semiconductor layer 30. In detail, the peripheral portion of the top surface of the first conductive semiconductor layer 30 has a first height, and the protrusions 31 having a second height higher than the first height are formed at the center portion of the first conductive semiconductor layer 30 surrounded by the peripheral portion. The light extraction efficiency can be more improved by the protrusions 31.

Referring to FIG. 8, the first electrode layer 80 is formed on the predetermined portion of the first conductive semiconductor layer 30, which is exposed as the growth substrate 10 is separated from the light emitting structure layer 60. Thus, the vertical type light emitting device capable of improving the light extraction efficiency can be manufactured.

As described above, the embodiment can provide a light emitting device having a novel structure and a method of manufacturing the same. In addition, the embodiment can provide a light emitting device having a light emitting structure layer, which can be easily separated from a growth substrate, and a method of manufacturing the same. Further, the embodiment can provide a light emitting device capable of preventing a light emitting structure layer from being damaged, and a method of manufacturing the same.

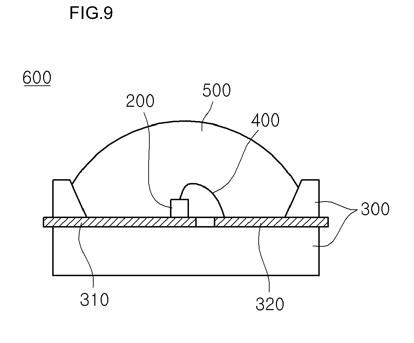

FIG. 9 is a sectional view showing a light emitting device package including the light emitting device according to the embodiments.

Referring to FIG. 9, the light emitting device package 600 includes a package body 300, first and second electrode layers 310 and 320 formed on the body 300, the light emitting device 200 provided on the package body 300 and electrically connected to the first and second electrode layers 310 and 320 and a molding member 500 that surrounds the light emitting device 200.

The package body 300 may include silicon, synthetic resin or metallic materials. An inclined surface may be formed around the light emitting device 200.

The first and second electrode layers 310 and 320 are electrically isolated from each other to supply power to the light emitting device 200. In addition, the first and second electrode layers 310 and 320 reflect the light emitted from the light emitting device 200 to improve the light efficiency and dissipate heat generated from the light emitting device 200 to the outside.

The lateral type light emitting device or the vertical type light emitting device can be used for the light emitting device 200, and the light emitting device 200 can be installed on the package body 300 or the first and second electrode layers 310 and 320.

The light emitting device 200 can be electrically connected to the first electrode 310 and/or the second electrode 320 through a wire 400. The vertical type light emitting device 200 is disclosed in the embodiment. In this case, the light emitting device 200 is electrically connected to the second electrode 320 through the wire 400. According to another embodiment, the lateral type light emitting device 200 can be employed. In this case, two wires 400 are used. In addition, if the light emitting device 200 is a flip chip type light emitting device, the wire 400 may not be used.

The molding member 500 surrounds the light emitting device 200 to protect the light emitting device 200. In addition, the molding member 500 may include luminescent materials to change the wavelength of the light emitted from the light emitting device 200.

The light emitting device package 600 according to the embodiment includes the light emitting device 200 having the light emitting structure layer, which is prevented from being damaged, so that light efficiency can be improved.

A plurality of light emitting device packages 600 according to the embodiment may be arrayed on a substrate, and an optical member including a light guide plate, a prism sheet, a diffusion sheet and a fluorescent sheet may be provided on the optical path of the light emitted from the light emitting device package 600. The light emitting device package, the substrate, and the optical member may serve as a backlight unit or a lighting unit. For instance, the lighting system may include a backlight unit, a lighting unit, an indicator, a lamp or a streetlamp.

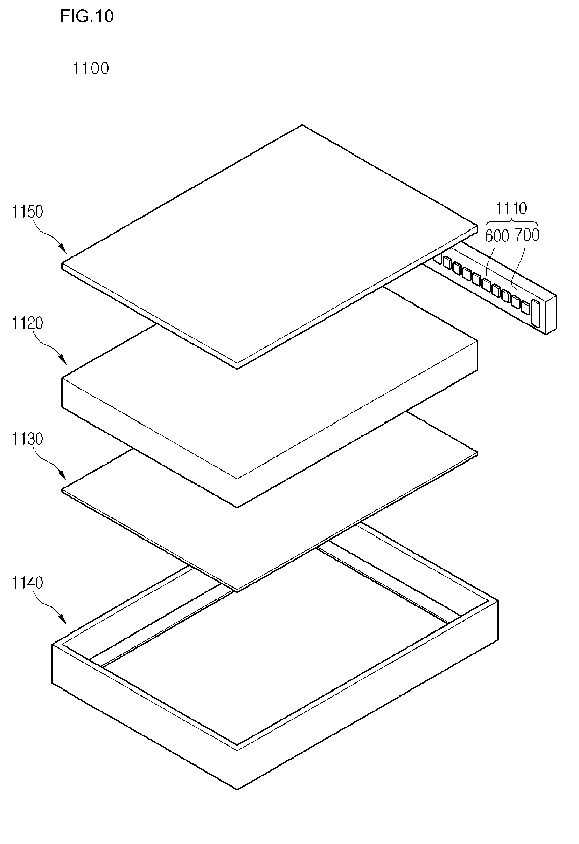

FIG. 10 is an exploded perspective view showing a backlight unit 1100 including the light emitting device package according to the embodiment. The backlight unit 1100 shown in FIG. 10 is an example of a lighting system and the embodiment is not limited thereto.

Referring to FIG. 10, the backlight unit 1100 includes a bottom frame 1140, a light guide member 1120 installed in the bottom frame 1140, and a light emitting module 1110 installed at one side or on the bottom surface of the light guide member 1120. In addition, a reflective sheet 1130 is disposed below the light guide member 1120.

The bottom frame 1140 has a box shape having an open top surface to receive the light guide member 1120, the light emitting module 1110 and the reflective sheet 1130 therein. In addition, the bottom frame 1140 may include metallic material or resin material, but the embodiment is not limited thereto.

The light emitting module 1110 may include a substrate 700 and a plurality of light emitting device packages 600 installed on the substrate 700. The light emitting device packages 600 provide the light to the light guide member 1120. According to the light emitting module 1110 of the embodiment, the light emitting device packages 600 are installed on the substrate 700. However, it is also possible to direct install the light emitting device 200 according to the embodiment.

As shown in FIG. 10, the light emitting module 1110 is installed on at least one inner side of the bottom frame 1140 to provide the light to at least one side of the light guide member 1120.

In addition, the light emitting module 1110 can be provided below the bottom frame 1140 to provide the light toward the bottom surface of the light guide member 1120. Such an arrangement can be variously changed according to the design of the backlight unit 1100 and the embodiment is not limited thereto.

The light guide member 1120 is installed in the bottom frame 1140. The light guide member 1120 converts the light emitted from the light emitting module 1110 into the surface light to guide the surface light toward a display panel (not shown).

The light guide member 1120 may include a light guide plate. For instance, the light guide plate can be manufactured by using acryl-based resin, such as PMMA (polymethyl methacrylate), PET (polyethylene terephthalate), PC (polycarbonate), COC or PEN (polyethylene naphthalate) resin.

An optical sheet 1150 may be provided over the light guide member 1120.

The optical sheet 1150 may include at least one of a diffusion sheet, a light collection sheet, a brightness enhancement sheet, and a fluorescent sheet. For instance, the optical sheet 1150 has a stack structure of the diffusion sheet, the light collection sheet, the brightness enhancement sheet, and the fluorescent sheet. In this case, the diffusion sheet uniformly diffuses the light emitted from the light emitting module 1110 such that the diffused light can be collected on the display panel (not shown) by the light collection sheet. The light output from the light collection sheet is randomly polarized and the brightness enhancement sheet increases the degree of polarization of the light output from the light collection sheet. The light collection sheet may include a horizontal prism sheet and/or a vertical prism sheet. In addition, the brightness enhancement sheet may include a dual brightness enhancement film and the fluorescent sheet may include a transmittive plate or a transmittive film including luminescent materials.

The reflective sheet 1130 can be disposed below the light guide member 1120. The reflective sheet 1130 reflects the light, which is emitted through the bottom surface of the light guide member 1120, toward the light exit surface of the light guide member 1120.

The reflective sheet 1130 may include resin material having high reflectivity, such as PET, PC or PVC resin, but the embodiment is not limited thereto.

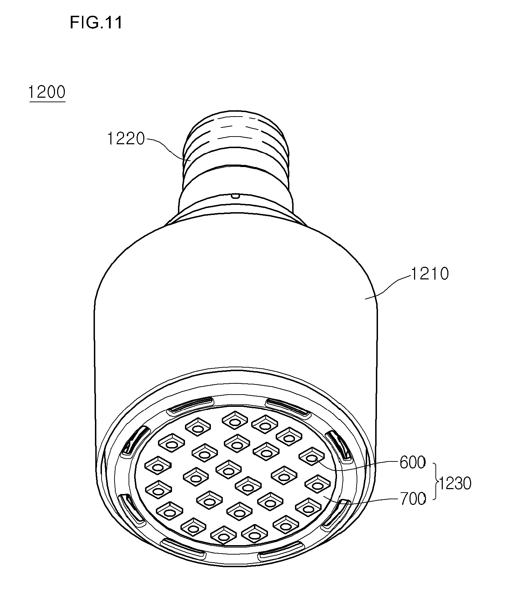

FIG. 11 is a perspective view showing a lighting unit 1200 including the light emitting device or the light emitting device package according to the embodiment. The lighting unit 1200 shown in FIG. 11 is an example of a lighting system and the embodiment is not limited thereto.

Referring to FIG. 11, the lighting unit 1200 includes a case body 1210, a light emitting module 1230 installed in the case body 1210, and a connection terminal 1220 installed in the case body 1210 to receive power from an external power source.

Preferably, the case body 1210 includes material having superior heat dissipation property. For instance, the case body 1210 includes metallic material or resin material.

The light emitting module 1230 may include a substrate 700 and at least one light emitting device package 600 installed on the substrate 700. According to the embodiment, the light emitting device package 600 is installed on the substrate 700. However, it is also possible to direct install the light emitting device 200 according to the embodiment.

The substrate 700 may include an insulating member printed with a circuit pattern. For instance, the substrate 700 includes a PCB (printed circuit board), an MC (metal core) PCB, an F (flexible) PCB, or a ceramic PCB.

In addition, the substrate 700 may include material that effectively reflects the light. The surface of the substrate 700 can be coated with a color, such as a white color or a silver color, to effectively reflect the light.

At least one light emitting device package 600 according to the embodiment can be installed on the substrate 700. Each light emitting device package 600 may include at least one LED (light emitting diode). The LED may include a colored LED that emits the light having the color of red, green, blue or white and a UV (ultraviolet) LED that emits UV light.

The LEDs of the light emitting module 1230 can be variously combined to provide various colors and brightness. For instance, the white LED, the red LED and the green LED can be combined to achieve the high color rendering index (CRI). In addition, a fluorescent sheet can be provided in the path of the light emitted from the light emitting module 1230 to change the wavelength of the light emitted from the light emitting module 1230. For instance, if the light emitted from the light emitting module 1230 has a wavelength band of blue light, the fluorescent sheet may include yellow luminescent materials. In this case, the light emitted from the light emitting module 1230 passes through the fluorescent sheet so that the light is viewed as white light.

The connection terminal 1220 is electrically connected to the light emitting module 1230 to supply power to the light emitting module 1230. Referring to FIG. 11, the connection terminal 1220 has a shape of a socket screw-coupled with the external power source, but the embodiment is not limited thereto. For instance, the connection terminal 1220 can be prepared in the form of a pin inserted into the external power source or connected to the external power source through a wire.

According to the lighting system as described above, at least one of the light guide member, the diffusion sheet, the light collection sheet, the brightness enhancement sheet and the fluorescent sheet is provided in the path of the light emitted from the light emitting module, so that the desired optical effect can be achieved.

As described above, since the lighting system includes the light emitting device or the light emitting device package having the light emitting structure layer, which is prevented from being damaged, the light efficiency can be improved.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A method of manufacturing a light emitting device, the method comprising:
partially forming a first buffer layer on a growth substrate, the first buffer layer having a Young's modulus smaller than that of the growth substrate; and
forming a light emitting structure layer on the growth substrate and the first buffer layer, the light emitting structure layer including a first conductive semiconductor layer, a second conductive semiconductor layer and an active layer interposed between the first and second conductive semiconductor layers.

2. The method of claim 1, further comprising forming a second buffer layer on the first buffer layer before the light emitting structure layer is formed, and
wherein the first buffer layer makes contact with the growth substrate, and the second buffer layer makes contact with the growth substrate and the first buffer layer..

3. The method of claim 2, further comprising forming an undoped nitride layer on the second buffer layer before the light emitting structure layer is formed.

4. The method of claim 2, wherein a thickness of the second buffer layer is smaller than a thickness of the first buffer layer.

5. The method of claim 1, further comprising forming an undoped nitride layer on the first buffer layer before the light emitting structure layer is formed.

6. The method of claim 1, wherein the first buffer layer has a thickness of 0.1 nm∼5.0µm, and wherein the first buffer layer includes oxide or nitride including at least one selected from the group consisting of Al, Ta, Ti, Mo, W, Pd, Ir, Rb, Si, and Cr.

7. The method of claim 1, wherein the first buffer layer formed on the growth substrate has an area corresponding to 30% to 95% based on a total area of the growth substrate.

8. The method of claim 1, wherein the first buffer layer has a bandgap energy lower than a bandgap energy of the growth substrate and higher than a bandgap energy of the light emitting structure layer.

9. The method of claim 1, wherein the first buffer layer is continuously formed along an outer peripheral portion of the growth substrate while surrounding a central portion of the growth substrate, and partially formed on the central portion of the growth substrate.

10. The method of claim 1, further comprising:
forming a second electrode layer on the light emitting structure layer;
separating the growth substrate and the first buffer layer from the light emitting structure layer; and
forming a first electrode layer on a predetermined portion of the first conductive semiconductor layer, which is exposed as the growth substrate and the first buffer layer are separated from the light emitting structure layer.

11. The method of claim 12, wherein a plurality of protrusions are formed on the predetermined portion of the first conductive semiconductor layer, which is exposed as the growth substrate and the first buffer layer are separated from the light emitting structure layer.

12. The method of claim 11, wherein the first conductive semiconductor layer, which is exposed as the growth substrate and the first buffer layer are separated from the light emitting structure layer, includes a peripheral portion having a first height and a central portion surrounded by the peripheral portion and formed with the protrusions having a second height higher than the first height.

13. A light emitting device comprising:
a light emitting structure layer including a first conductive semiconductor layer, a second conductive semiconductor layer and an active layer interposed between the first and second conductive semiconductor layers,
wherein a first surface of the first conductive semiconductor layer faces the active layer and a plurality of protrusions are formed on a second surface of the first conductive semiconductor layer, and
wherein the second surface of the first conductive semiconductor layer includes a peripheral portion and a central portion surrounded by the peripheral portion, and the protrusions are formed on the central portion while being spaced apart from each other.

14. The light emitting device of claim 13, further comprising a first buffer layer under the first conductive semiconductor layer and a growth substrate under the first buffer layer, wherein at least a part of the first buffer layer is disposed between the protrusions.

15. The light emitting device of claim 14, wherein the first buffer layer is partially formed between the first conductive semiconductor layer and the growth substrate.
